(19) Europäisches Patentamt
European Patent Office
Office européen des brevets

(11) **EP 2 791 637 B1**

(12) **FASCICULE DE BREVET EUROPEEN**

(45) Date de publication et mention de la délivrance du brevet:
**21.10.2015 Bulletin 2015/43**

(21) Numéro de dépôt: **12794736.4**

(22) Date de dépôt: **04.12.2012**

(51) Int Cl.:
**G01J 3/42** (2006.01)          **G01J 4/00** (2006.01)
**G01N 21/21** (2006.01)

(86) Numéro de dépôt international:
**PCT/EP2012/074375**

(87) Numéro de publication internationale:
**WO 2013/087456 (20.06.2013 Gazette 2013/25)**

(54) **DISPOSITIF DE MESURE DE L'ETAT DE POLARISATION D'UNE ONDE INCIDENTE DE FREQUENCE DE 10 GHZ A 30 THZ**

VORRICHTUNG ZUM MESSEN DES POLARISIERUNGSZUSTANDES EINER EINFALLENDEN WELLE MIT EINER FREQUENZ VON 10 GHZ BIS 30 THZ

DEVICE FOR MEASURING THE STATE OF POLARIZATION OF AN INCIDENT WAVE OF FREQUENCY 10 GHZ TO 30 THZ

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.12.2011 FR 1161615**

(43) Date de publication de la demande:
**22.10.2014 Bulletin 2014/43**

(73) Titulaire: **Centre National de la Recherche Scientifique (CNRS)**
**75016 Paris (FR)**

(72) Inventeurs:
• **KNAP, Wojciech**
  **F-34980 Saint Gely Du Fesc (FR)**
• **TEPPE, Frédéric**
  **F-34160 Castries (FR)**
• **DIAKONOVA, Nina**
  **F-34080 Montpellier (FR)**
• **DIAKONOV, Michel**
  **F-34080 Montpellier (FR)**
• **KLIMENKO, Oleg**
  **Moscow 119146 (RU)**
• **GANICHEV, Sergey**
  **93161 Sinzing (DE)**
• **DREXLER, Christop**
  **93053 Regensburg (DE)**

(74) Mandataire: **Regimbeau**
**Parc d'affaires Cap Nord A**
**2, allée Marie Berhaut**
**CS 71104**
**35011 Rennes Cedex (FR)**

(56) Documents cités:
**WO-A1-2006/072762     JP-A- 2010 219 442**

• **KIM SANGWOO ET AL: "Room temperature terahertz detection based on bulk plasmons in antenna-coupled GaAs field effect transistors", APPLIED PHYSICS LETTERS, AIP, AMERICAN INSTITUTE OF PHYSICS, MELVILLE, NY, US, vol. 92, no. 25, 27 juin 2008 (2008-06-27) , pages 253508-253508, XP012107736, ISSN: 0003-6951, DOI: 10.1063/1.2947587**
• **WOJCIECH KNAP ET AL: "Field Effect Transistors for Terahertz Detection and Emission", JOURNAL OF INFRARED, MILLIMETER, AND TERAHERTZ WAVES, SPRINGER US, BOSTON, vol. 32, no. 5, 4 mai 2010 (2010-05-04), pages 618-628, XP019906672, ISSN: 1866-6906, DOI: 10.1007/S10762-010-9647-7**

EP 2 791 637 B1

**Description**

L'invention concerne un dispositif de mesure de l'état de polarisation d'une onde incidente de fréquence supérieure à 10 GHz.

De telles ondes sont également appelées ondes sub-Térahertz ou Térahertz (sub-THz ou THz) ou encore ondes millimétriques et submillimétriques. La gamme de fréquences des ondes concernées est traditionnellement divisée en trois parties qui se placent respectivement de 10 à 100 GHz, de 100 GHz à 1 THz et de 1 THz à 6 THz pour la dernière. Dans le reste de ce document les trois gammes de fréquences énoncées plus haut seront désignées de manière générale sous le seul terme THz.

La mesure de l'état de polarisation de la lumière et particulièrement son ellipticité transmise, réfléchie, ou dispersée représente une technique d'analyse puissante de l'anisotropie de certains matériaux ou des différents états de la matière tels que les plasmas, les gaz, les solides massifs ou de surfaces, aussi bien que des tissus biologiques. Quelques exemples représentatifs sont la polarimétrie en tokamak pour mesurer des champs électriques et magnétiques dans des gaz ionisés aussi bien que la densité du plasma, la surveillance et le contrôle de la croissance des matériaux, la spectroscopie par dichroïsme circulaire et la dispersion rotatoire optique de protéines et de molécules. Il en est de même pour les mesures sans contact et non destructives de surfaces et de films ultra-minces, ou encore l'analyse de gaz et des constituants d'aérosol dans l'atmosphère terrestre par la télédétection optique sensible à la polarisation.

Une des méthodes reconnues permettant d'obtenir des informations quant à l'état de polarisation de la lumière, repose sur la mesure d'une différence de chemins optiques. Dans le cas où il est nécessaire de mesurer l'ellipticité dynamique de la lumière polarisée, alors l'ellipticité résolue en temps peut être mesurée par transmission de la lumière elliptique au travers d'un prisme analyseur en rotation rapide, placé en face d'un photo-détecteur. Il est aussi possible d'utiliser une technique pompe-sonde.

Plusieurs types de détecteurs sensibles à la polarisation sont utilisés en polarimétrie THz comme les photoconducteurs multi-contacts. Mais plusieurs types d'effets induisant une ellipticité ont également été proposés dans les publications [1], [2] et [3], tels que : l'effet photo-galvanique circulaire dans la publication [4], l'effet galvanique dépendant du spin dans la publication [5], l'effet de traînée de photons circulaire dans la publication [6] et l'effet Hall alternatif circulaire dans la publication [7]. Toutefois, la polarisation de la lumière transmise ou réfléchie est généralement faible, et la spectroscopie THz polarisée manque encore de détecteurs efficaces.

Récemment, une nouvelle classe de détecteurs de rayonnement THz a émergé. Selon la proposition faite dans la publication [8], la détection de rayonnement THz par des transistors à effet de champ (FET) a été démontrée.

Il a été montré que les FETs peuvent fonctionner en tant que détecteurs résonants en tension dans les publications [9], [10], [11] et [12], ou en tant que détecteurs à large bande ou dits non résonants dans les publications [13], [14], [15] et [16].

Le document [17] concerne un détecteur sensible à la polarisation linéaire d'une onde de 100 GHz par des FETs, dans lequel le signal de détection est contrôlé en fonction de la tension entre la grille et la source et en fonction d'un angle entre un axe de symétrie du transistor et la direction de polarisation linéaire de l'onde.

Le document [18] décrit un détecteur sensible aux ondes THz, qui comporte un FET à couplage par antenne. Ce dispositif fonctionne en couplant de manière capacitive des ondes Térahertz dans le transistor et en relevant les modifications du courant entre la source et le drain.

Toutefois, ce document indique que ce détecteur, à température ambiante, répond seulement aux ondes ayant une polarisation orthogonale par rapport à ce qui était attendu par le design de l'antenne, si bien que le détecteur n'est sensible qu'aux polarisations verticales.

L'objectif de l'invention est d'obtenir un dispositif de mesure, qui soit sensible à l'ellipticité de l'onde incidente.

L'invention vise à obtenir un dispositif de mesure de l'état de polarisation circulaire d'une onde incidente de fréquence allant de 10 GHz à 30THz, qui permet d'effectuer une mesure avec résolution temporelle de quelques picosecondes à température ambiante de cet état de polarisation, et qui soit simple à mettre en oeuvre et de faible coût. En particulier, le dispositif doit permettre de détecter l'ellipticité de l'état de polarisation de l'onde.

A cet effet, un premier objet de l'invention est un dispositif de mesure de l'état de polarisation d'une onde incidente de fréquence supérieure à 10 GHz et inférieure à 30 THz, le dispositif comportant :

- au moins un transistor à effet de champ comportant au moins une borne de source, au moins une borne de drain et au moins une borne de grille,
- une antenne de réception de l'onde incidente de fréquence supérieure à 10 GHz et inférieure à 30 THz, reliée au moins à la borne de grille,

la borne de source et la borne de drain étant reliées à un circuit pour la mesure d'un signal électrique de détection présent entre la borne de source et la borne de drain,
caractérisé en ce que

l'antenne de réception de l'onde incidente de fréquence supérieure à 10 GHz et inférieure à 30 THz est bidirectionnelle, est prévue à l'extérieur du transistor à effet de champ, est distincte des bornes du transistor et comporte une première partie d'antenne reliée à la borne de source, une deuxième partie d'antenne reliée à la borne de drain et une troisième partie d'antenne bidirectionnelle reliée à la borne de grille,

la première partie d'antenne et la troisième partie d'antenne bidirectionnelle étant agencées pour détecter une première composante de polarisation de l'onde, colinéaire à une première direction déterminée et provoquant l'apparition dans le transistor entre la borne de source et la borne de grille d'une première tension alternative de détection de la première composante suivant la première direction,

la deuxième partie d'antenne et la troisième partie d'antenne bidirectionnelle étant agencées pour détecter une deuxième composante de polarisation de l'onde, colinéaire à une deuxième direction déterminée et provoquant l'apparition dans le transistor entre la borne de drain et la borne de grille d'une deuxième tension alternative de détection de la deuxième composante suivant la deuxième direction,

la première direction étant non parallèle à la deuxième direction et étant non confondue avec la deuxième direction,

le transistor étant agencé pour générer, comme signal électrique de détection entre la borne de source et la borne de drain, une tension continue de détection dont une partie est déterminée par l'état de polarisation elliptique de l'onde par interférence dans le transistor entre la première tension alternative de détection et la deuxième tension alternative de détection, le circuit étant prévu pour analyser l'état de polarisation elliptique de l'onde par mesure du signal électrique de détection entre la borne de source et la borne de drain..

Suivant un mode de réalisation de l'invention, le transistor est agencé pour avoir une longueur de grille, prise dans la direction allant de la source au drain, inférieure ou égale à deux fois la longueur d'amortissement caractéristique de la première tension alternative et de la deuxième tension alternative dans le canal du transistor.

Suivant un mode de réalisation de l'invention, le transistor est agencé pour avoir une longueur de grille, prise dans la direction allant de la source au drain, inférieure ou égale à deux fois une longueur d'amortissement caractéristique égale à

$$ L = \sqrt{\frac{\mu |U|}{\omega}} $$

où $\omega$ est la pulsation de l'onde, $\mu$ est la mobilité des électrons dans le canal du transistor, U est l'écart de tension au seuil, $U = U_t - U_{gs}$ pour $U_{gs} > U_t$ et $U = \eta kT/e$ pour $U_{gs} \leq U_t$, où $U_t$ est la tension de seuil du transistor et $U_{gs}$ est la tension continue de polarisation appliquée entre la borne de grille et la borne de source, $\eta$ est le coefficient d'idéalité, T est la température, k est la constante de Boltzmann.

Suivant un mode de réalisation de l'invention, la première partie d'antenne comporte un premier bras d'antenne et la troisième partie d'antenne bidirectionnelle comporte un troisième bras d'antenne, le premier bras d'antenne et le troisième bras d'antenne étant dirigés suivant la première direction déterminée en étant opposés l'un de l'autre pour la détection de la première composante de polarisation de l'onde, colinéaire à la première direction,

la deuxième partie d'antenne comportant un deuxième bras d'antenne et la troisième partie d'antenne bidirectionnelle comportant un quatrième bras d'antenne, le deuxième bras d'antenne et le quatrième bras d'antenne étant dirigés suivant la deuxième direction déterminée en étant opposés l'un de l'autre pour la détection de la deuxième composante de polarisation de l'onde, colinéaire à la deuxième direction.

Suivant un mode de réalisation de l'invention, la première direction et la deuxième direction sont perpendiculaires.

Suivant un mode de réalisation de l'invention, le premier bras est symétrique par rapport à la première direction.

Suivant un mode de réalisation de l'invention, le deuxième bras est symétrique par rapport à la première direction.

Suivant un mode de réalisation de l'invention, le troisième bras est symétrique par rapport à la deuxième direction.

Suivant un mode de réalisation de l'invention, le quatrième bras est symétrique par rapport à la deuxième direction.

Suivant un mode de réalisation de l'invention, le premier bras et/ou le deuxième bras et/ou le troisième bras et/ou le quatrième bras sont de forme triangulaire.

Suivant un mode de réalisation de l'invention, le premier bras et/ou le deuxième bras et/ou le troisième bras et/ou le quatrième bras sont chacun planaires.

Suivant un mode de réalisation de l'invention, le dispositif comporte en outre au moins une lame, la lame étant quart d'onde par rapport à la fréquence de l'onde incidente, la lame étant mise en rotation par un dispositif rotatif (ROT) autour d'un axe (AX) de rotation azimutal, la lame étant traversée par cette onde incidente pour la transmettre à l'antenne (3).

Suivant un mode de réalisation de l'invention, il est prévu un dispositif pour déterminer l'angle (ANG) de rotation de la lame (LAM) autour de l'axe (AX) de rotation en fonction du temps,

le circuit étant relié à un dispositif (COMP) de traitement de données permettant une mesure différentielle de l'état de polarisation elliptique en fonction de l'angle (ANG) de rotation et en fonction du signal électrique ($\Delta U$) de détection.

L'invention sera mieux comprise à la lecture de la description qui va suivre, donnée uniquement à titre d'exemple non limitatif en référence aux dessins annexés, sur lesquels :

- la figure 1 est une vue schématique d'un exemple de réalisation du dispositif de mesure suivant l'invention,
- la figure 2 est un exemple d'utilisation de dispositif dans un schéma de mesure
- la figure 2A est une vue schématique du profil de tension alternative dans le canal sous la grille du transistor du dispositif de mesure suivant l'invention, dans le cas d'une grille longue,
- la figure 2B est une vue schématique du profil en tension du canal sous la grille du transistor du dispositif de mesure suivant l'invention, dans le cas d'une grille courte,
- la figure 3 est un schéma d'un exemple de dispositif de mesure suivant l'invention, prévu pour extraire une partie de la tension continue due à l'ellipticité de l'onde,
- la figure 4 représente un exemple de polarisation elliptique pouvant être détecté par le dispositif suivant l'invention,
- la figure 5 représente un dispositif ne permettant pas de mesurer l'état de polarisation mais permettant seulement de détecter une onde polarisée linéairement,

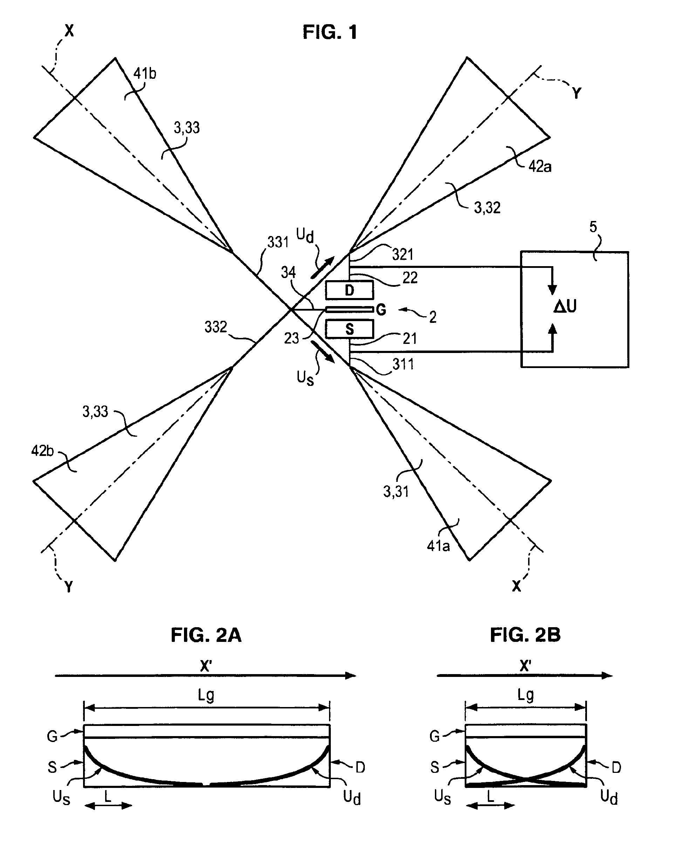

A la figure 1 est représenté un dispositif de mesure de l'état de polarisation d'une onde ou rayonnement (ou radiation, ces termes étant employés indifféremment dans ce qui suit) THz ou submillimétrique, de fréquence comprise entre 10 GHz et 30 THz, cette onde étant appelée THz dans ce qui suit.

Le dispositif 1 de mesure comporte au moins un transistor à effet de champ 2 (appelé FET) comportant une borne 21 de source, une borne 22 de drain et une borne 23 de grille. Ces bornes 21, 22 et 23 permettent la connexion électrique du FET 2 à un ou plusieurs circuit(s) électrique(s) extérieur(s).

Une antenne 3 bidirectionnelle de réception de l'onde THz incidente de fréquence supérieure à 10 GHz et inférieure à 30 THz est prévue dans le dispositif 1. L'antenne est destinée à séparer les deux composantes de polarisation de l'onde incidente et coupler une composante avec le canal de transistor du coté source et une autre composante avec le canal du côté drain. Cette antenne 3 est reliée à la borne 21 de source, à la borne 22 de drain, et à la borne 23 de grille. L'antenne 3 comporte une première partie 31 d'antenne reliée à la borne 21 de source, une deuxième partie 32 d'antenne reliée à la borne 22 de drain et une troisième partie 33 d'antenne bidirectionnelle reliée à la borne 23 de grille. L'antenne 3 est prévue à l'extérieur du transistor FET 2. L'antenne 3 est distincte des bornes 21, 22, 23 du transistor 2,

La première partie 31 d'antenne et la troisième partie 33 d'antenne bidirectionnelle sont agencées pour détecter une première composante de polarisation de l'onde, colinéaire à une première direction déterminée X. Cette première composante de polarisation de l'onde incidente provoque l'apparition dans le transistor 2 entre la borne 21 de source et la borne 23 de grille d'une première tension alternative Us de détection de la première composante suivant la première direction X.

La deuxième partie 32 d'antenne et la troisième partie 33 d'antenne bidirectionnelle sont agencées pour détecter une deuxième composante de polarisation de l'onde, colinéaire à une deuxième direction déterminée Y. Cette deuxième composante de polarisation de l'onde provoque l'apparition dans le transistor 2 entre la borne 22 de drain et la borne 23 de grille d'une deuxième tension alternative Ud de détection de la deuxième composante suivant la deuxième direction Y.

La première direction X est non parallèle à la deuxième direction Y et est non confondue avec cette deuxième direction Y, et est par exemple sécante de la deuxième direction Y.

La borne 21 de source et la borne 22 de drain sont reliées à un circuit 5 pour la mesure d'un signal électrique $\Delta U$ de détection présent entre la borne 21 de source et la borne 22 de drain.

Le transistor 2 est agencé pour générer, comme signal électrique $\Delta U$ de détection entre la borne 21 de source et la borne 22 de drain, une tension continue $\Delta U$ de détection de l'état de polarisation elliptique de l'onde par interférence dans le transistor 2 entre la première tension alternative Us de détection et la deuxième tension alternative Ud de détection. Le circuit 5 est un circuit d'enregistrement de la tension électrique $\Delta U$ mesurée entre la borne 21 de source et la borne 22 de drain.

Le circuit 5 est prévu pour mesurer le signal électrique $\Delta U$ de détection entre la borne 21 de source et la borne 22 de drain. La tension continue $\Delta U$ contient l'information sur l'état de polarisation elliptique de l'onde. De ce fait, le signal électrique $\Delta U$ de détection entre la borne 21 de source et la borne 22 de drain est une tension continue ($\Delta U$) de détection dont une partie est déterminée par l'état de polarisation elliptique de l'onde par interférence dans le transistor 2 entre la première tension alternative Us de détection et la deuxième tension alternative Ud de détection.

La polarisation elliptique est décrite comme la superposition de deux composantes linéaires ayant des axes de polarisation différents.

Grâce à l'invention, un transistor 2 à effet de champ peut être utilisé comme un mesureur de degré de polarisation circulaire ou elliptique de rayonnement THz.

La sensibilité des FETs est particulièrement élevée (5 kV/W) et leur puissance équivalente de bruit (NEP) est de l'ordre de $10^{-10}$ W/Hz$^{0,5}$.

Ci-dessous est décrit un mode de réalisation de l'antenne 3.

La première partie 31 d'antenne comporte un premier bras 41a d'antenne.

La troisième partie 33 d'antenne bidirectionnelle comporte un troisième bras 41b d'antenne.

Le premier bras 41a d'antenne et le troisième bras 41b d'antenne sont dirigés suivant une première direction déterminée X, et le premier bras 41a d'antenne est à l'opposé du troisième bras 41b d'antenne, pour la réception de la première composante de polarisation de l'onde incidente, colinéaire à la première direction X.

La deuxième partie 32 d'antenne comporte un deuxième bras 42a d'antenne.

La troisième partie 33 d'antenne bidirectionnelle comporte un quatrième bras 42b d'antenne.

Le deuxième bras 42a d'antenne et le quatrième bras 42b d'antenne sont dirigés suivant la deuxième direction déterminée Y, et le deuxième bras 42a d'antenne est à l'opposé du quatrième bras 42b d'antenne, pour la réception de la deuxième composante de polarisation de l'onde incidente, colinéaire à la deuxième direction Y.

La première partie 31 d'antenne et la troisième partie 33 d'antenne bidirectionnelle sont agencées pour définir un premier axe préférentiel de polarisation de rayonnement qui correspond à la direction passant par les bras 41a et 41b de l'antenne. Les bras d'antenne 41a, 41b sont par exemple dirigés suivant la même première direction déterminée X. Le premier axe préférentiel de polarisation de rayonnement est par exemple la première direction X.

La deuxième partie 32 d'antenne et la troisième partie 33 d'antenne bidirectionnelle sont agencées pour définir un deuxième axe préférentiel de polarisation de rayonnement qui correspond à la direction passant par les bras 42a et 42b de l'antenne. Les deux bras d'antenne 42a, 42b sont par exemple dirigés suivant la même deuxième direction déterminée Y. Le deuxième axe préférentiel de polarisation de rayonnement est par exemple la deuxième direction Y.

Les bras 41a, 41b, 42a, 42b sont par exemple métallisés.

La première direction X et la deuxième direction Y sont par exemple perpendiculaires.

Dans un mode de réalisation, le premier bras 41a est symétrique par rapport à la première direction X.

Dans un mode de réalisation, le deuxième bras 41b est symétrique par rapport à la première direction X.

Dans un mode de réalisation, le troisième bras 42a est symétrique par rapport à la deuxième direction Y.

Dans un mode de réalisation, le quatrième bras 42b est symétrique par rapport à la deuxième direction Y.

Dans un mode de réalisation, le premier bras 41 a et/ou le deuxième bras 41b et/ou le troisième bras 42a et/ou le quatrième bras 42b sont de forme triangulaire, par exemple isocèle par symétrie par rapport à la direction X pour 41a et 41b et par symétrie par rapport à la direction Y pour 42a et 42b.

Dans un mode de réalisation, le premier bras 41a et/ou le deuxième bras 41b et/ou le troisième bras 42a et/ou le quatrième bras 42b sont chacun de forme plane.

Dans le mode de réalisation représenté à la figure 1, à la fois les bras 41a et 41b sont symétriques par rapport à la première direction X, les bras 42a, 42b sont symétriques par rapport à la deuxième direction Y, les bras 41a, 41b, 42a, 42b sont chacun triangulaires et de forme plane, par exemple isocèles dans un même plan.

Les bras 41a, 41b, 42a, 42b d'antenne occupent, par exemple, un secteur angulaire centré sur la direction X ou Y.

Les bras 41a, 41b d'antenne occupent, par exemple, chacun un secteur angulaire ayant une ouverture totale comprise entre 0 ° et 180 °, et notamment compris entre 20° et 40°.

La taille des antennes est adaptée à la longueur d'onde de l'onde incidente, et est de l'ordre de 300 $\mu$m à 3 mm pour chaque partie 31, 32, 33.

Par exemple, à la figure 1, les bras triangulaires 41 a, 41b ont une médiatrice d'une longueur de 500 $\mu$m suivant la direction X et les bras triangulaires 42a, 42b ont une médiatrice d'une longueur de 500 $\mu$m suivant la direction Y, les bras 41a, 41b d'antenne occupent chacun un secteur angulaire ayant une ouverture totale égale à 30°, les bras 42a, 42b d'antenne occupent chacun un secteur angulaire ayant une ouverture totale égale à 30°.

La bidirectionnalité de la troisième partie 33 d'antenne est telle, qu'elle permet aux première et troisième parties d'antenne de recevoir la première composante de polarisation de l'onde incidente, et aux deuxième et troisième parties d'antenne de recevoir l'autre deuxième composante de polarisation de l'onde incidente, qui est différente de la première. De ce fait, la troisième partie de l'antenne peut se composer d'un bras, ou de plusieurs bras connectées entre eux par des brins, ou encore différemment.

Aux figures, G désigne la grille du FET 2, S désigne la source du FET 2 et D désigne le drain du FET 2, un tel transistor à effet de champ 2 comportant de manière connue sous la grille G un canal entre la source S et le drain D.

Dans le mode de réalisation représenté, se trouvant être non limitatif, la troisième partie 3 d'antenne bidirectionnelle comporte un troisième brin 331 servant à la connexion du bras 41b à la grille et un quatrième brin 332 servant à la connexion du bras 42b à la borne 23 de grille. Le troisième brin 331 est par exemple dirigé suivant la première direction X. Le quatrième brin 332 est par exemple dirigé suivant la deuxième direction Y. Les brins 331 et 332 sont par exemple connectés entre eux et ils sont également connectés à la borne 23 de grille par une branche 34 de connexion.

Dans le mode de réalisation non limitatif représenté, le brin 331 est dirigé suivant le bras 41b. Dans le mode de réalisation représenté, le deuxième brin est dirigé suivant le bras 42b.

Un premier brin 311 de connexion du premier bras 41a d'antenne à la borne 21 de source est prévu.

Un deuxième brin 321 de connexion du deuxième bras 42a d'antenne à la borne 22 de drain est prévu.

Dans le mode de réalisation non limitatif représenté, le troisième brin 331 est perpendiculaire au quatrième brin 332.

L'antenne 3 peut être divisée en deux parties : la partie source et la partie drain. Les axes de polarisation X et Y sont, par exemple, perpendiculaires entre eux, ce qui permet donc la détection potentielle d'un rayonnement polarisé elliptiquement ou circulairement. Dans ce cas, une composante de la polarisation du rayonnement incident excite le plasma d'électrons du côté source, et l'autre composante du côté drain. Lorsque la grille est suffisamment courte, les zones d'excitation du plasma côté drain et côté source se chevauchent dans le canal. Il en résulte une tension $\Delta U$ constante drain-source dont une partie est due à l'interférence entre les deux excitations. L'amplitude de cette interférence augmente lorsque la polarisation de l'onde devient circulaire. Dans le cas d'une polarisation linéaire l'amplitude de la tension due à l'interférence est égale à zéro.

Lorsque la grille n'est pas suffisamment courte, les excitations de plasma s'amortissent sans avoir interféré et la tension $\Delta U$ constante drain-source ne contient pas d'information sur l'ellipticité de la lumière.

Dans un mode de réalisation, le transistor FET 2 peut être par exemple du type MOSFET (en anglais : Métal Oxyde Semiconductor Field Effect Transistor pour transistor à effet de champ métal / oxyde / semi-conducteur) pour lequel la longueur Lg de la grille est égale à la longueur du canal (longueur de la source au drain) ou du type HEMT (en anglais : High Electron Mobility Transistor pour transistor à grande mobilité d'électrons) pour lequel la longueur Lg de la grille est inférieure à la longueur du canal (longueur de la source au drain).

Suivant un mode de réalisation de l'invention, le transistor 2 est agencé pour avoir une longueur Lg de grille G, prise dans la direction allant de la source S au drain D, inférieure ou égale à deux fois la longueur L d'amortissement caractéristique de la première tension alternative Us et de la deuxième tension alternative Ud dans le canal du transistor 2, c'est-à-dire

$$\text{Lg} \leq 2\,\text{L}.$$

Ce mode de réalisation est illustré à la figure 2B.

Suivant un mode de réalisation de l'invention, le transistor 2 est agencé pour avoir une longueur Lg de grille G, prise dans la direction allant de la source S au drain D, inférieure ou égale à deux fois une longueur L d'amortissement caractéristique égale à

$$L = \sqrt{\frac{\mu |U|}{\omega}}$$

où $\omega$ est la pulsation de l'onde, est la mobilité des électrons dans le canal du transistor 2, U est l'écart de tension au seuil, $U = U_t - U_{gs}$ pour $U_{gs} > U_t$ et $U = \eta kT/e$ pour $U_{gs} \leq U_t$, où $U_t$ est la tension de seuil du transistor 2 et $U_{gs}$ est la tension continue de polarisation appliquée entre la borne de grille et la borne de source, $\eta$ est le coefficient d'idéalité, T est la température, k est la constante de Boltzmann. Pour une fréquence incidente de 1 THz, une mobilité $\mu$ de 300 cm2/V.s et une tension U d'écart au seuil de 100 mV, la longueur L d'amortissement caractéristique est de 21.8 nm. La longueur Lg de grille doit donc être inférieure ou égale à 43.6 nm.

Pour une fréquence de 300 GHz et les mêmes autres valeurs de tension U d'excursion et de mobilité $\mu$, la longueur L d'amortissement caractéristique est de 39.8 nm. La longueur Lg de grille doit donc être inférieure ou égale à 79.6 nm.

Pour une fréquence de 300 GHz, une mobilité électronique $\mu$ de 2000 cm2/V.s et une tension U d'excursion de 100 mV, la longueur L d'amortissement est de 102.8 nm ; la longueur de grille doit donc être inférieur ou égale à 205.6 nm.

Par exemple, pour un transistor 2 MOSFET, la longueur du canal est 100 nm, de même que pour la longueur du drain à la source.

Le dispositif suivant la figure 1 permet la détection de la polarisation circulaire ou elliptique du rayonnement. La longueur du canal du transistor 2 est assez courte pour qu'avant d'être atténuée, la perturbation du gaz d'électrons du côté drain se mélange avec la perturbation du côté source. X et Y sont les axes de polarisation des deux parties de l'antenne permettant l'excitation côté source et côté drain, respectivement.

Aux figures 2A et 2B la longueur de la grille G et du canal situé sous la grille G est représentée suivant l'axe longitudinal x' allant entre le drain D et la source S. A la figure 2A la longueur de grille ($L_g$) est grande ($L_g$ >2L), L étant la longueur d'amortissement des ondes de plasma. A la figure 2B la longueur de grille est petite (2L> $L_g$).

La figure 2A décrit le cas selon lequel le canal est plus long que deux fois la longueur d'amortissement. Les deux perturbations du gaz d'électrons ne se superposent pas au milieu du canal, il n'y a donc pas de mélange des deux signaux et le transistor ne peut donc pas détecter la polarisation elliptique. Seule la polarisation linéaire peut être détectée. Par exemple, quand l'axe de polarisation coïncide (pour simplifier la démonstration) avec la direction X, alors une tension alternative Us n'est créée qu'entre la borne de source et la borne de grille, et la tension alternative Ud entre la borne de drain et la borne de grille est égale à zéro. Le signal ΔU de détection, appelé $\Delta U_{linéaireX}$, est déterminé par la tension continue entre la borne de source et la borne de grille. Si l'axe de polarisation coïncide avec la direction Y , alors une tension alternative Ud n'est créée qu'entre la borne de drain et la borne de grille et une tension alternative Us entre la borne de source et la borne de grille est égale à zéro. Le signal $\Delta U$ de détection, $\Delta U_{linéaireY}$, est alors de signe opposé à celui de $\Delta U_{linéaireX}$, ce qui fait du transistor avec antennes un dispositif également sensible à l'état de polarisation linéaire.

La figure 2B correspond au cas selon lequel le canal est plus court ou de dimension égale à deux fois la longueur d'amortissement. Autrement dit, les deux perturbations côté source et drain ne sont pas complètement amorties en arrivant au milieu du canal et se mélange donc en permettant la détection de la polarisation elliptique. Le signal $\Delta U$ de détection, appelé $\Delta U_{circulaire}$, est influencé par la taille de la zone de superposition des excitations. Le signe (négatif ou positif) d'une partie de tension continue créée dans cette zone est déterminée par l'état de polarisation circulaire de rayonnement (circulaire droit ou circulaire gauche).

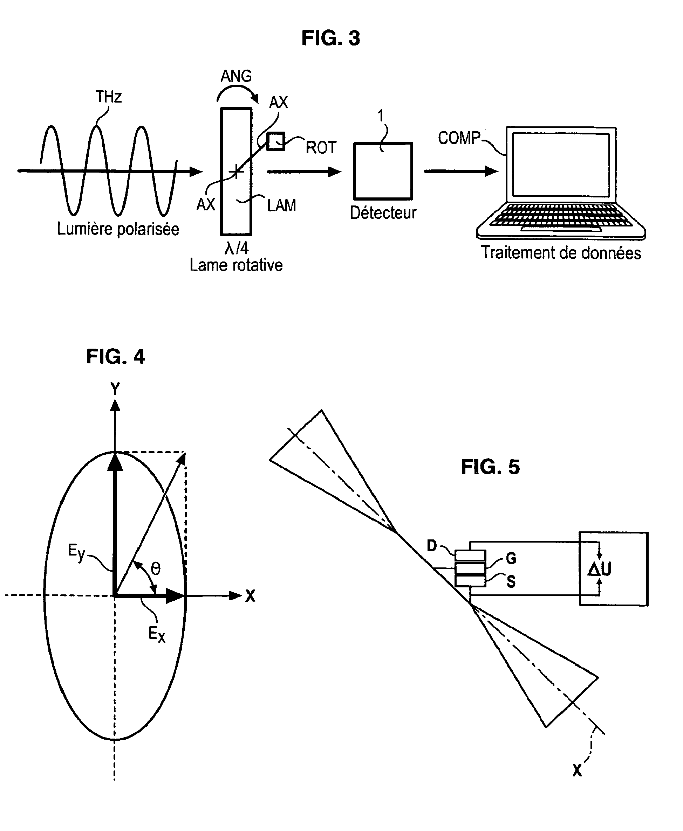

Une des possibilités d'utilisation du dispositif de mesure suivant l'invention est un dispositif expérimental selon la figure 3. La Figure 3 représente schématiquement un mode de réalisation expérimental et optionnel du dispositif de mesure de l'état de polarisation de la lumière et n'est pas limitative des utilisations du dispositif de mesure suivant l'invention.

Suivant ce mode réalisation optionnel, il est prévu en plus :

- au moins une lame LAM, la lame étant quart d'onde par rapport à la fréquence de l'onde incidente, la lame étant mise en rotation par un dispositif rotatif ROT autour d'un axe AX de rotation azimutal, la lame étant traversée par cette onde incidente pour la transmettre à l'antenne 3,
- un dispositif pour déterminer l'angle ANG de rotation de la lame LAM autour de l'axe AX de rotation en fonction du temps,
- le circuit étant relié à un dispositif COMP de traitement de données permettant une mesure différentielle de l'état de polarisation elliptique en fonction de l'angle ANG de rotation et en fonction du signal électrique ΔU de détection.

Bien entendu, le dispositif de mesure suivant l'invention peut ne pas comporter ces caractéristiques, qui sont chacune optionnelles.

Ainsi, dans d'autres modes de réalisation, l'onde incidente THz peut arriver directement sur l'antenne 3.

Le mode de réalisation optionnel du dispositif représenté à la figure 3 repose sur la mesure de la tension continue aux bornes du canal du transistor en fonction de l'angle de rotation de la lame LAM à retard de phase (lame λ/4). Cette tension mesurée entre source et drain comporte l'information relative à l'ellipticité de l'onde incidente, issue du mélange entre les 2 perturbations du gaz d'électrons intervenant côté source et côté drain (cf. figure 4). Sur ce schéma, une radiation THz de polarisation inconnue traverse une lame quart d'onde en rotation azimutale et illumine le détecteur 1 de polarisation elliptique Terahertz décrit précédemment. Les variations d'intensité du signal source-drain, induites par les changements d'ellipticité de l'onde THz, en fonction de l'angle azimutal sont enregistrées et traitées par ordinateur COMP. Le signal enregistré en fonction de l'angle de rotation azimutale de la lame λ/4 (où λ est la longueur d'onde de l'onde incidente THz), permet une mesure différentielle de l'ellipticité et une reconstitution des axes de polarisation de l'onde incidente THz.

Il peut être prévu que le dispositif pour déterminer l'angle (ANG) de rotation de la lame autour de l'axe de rotation en fonction du temps soit par exemple le dispositif ROT d'entrainement en rotation. Le dispositif de traitement de données permet de déterminer par exemple les valeurs numériques Ex et Ey de la première composante de polarisation $E_x$ suivant la première direction X et de la deuxième composante de polarisation $E_y$ suivant la deuxième direction Y.

La vitesse à laquelle le détecteur peut effectuer la mesure lui permet d'être potentiellement utilisé dans des dispositifs de mesures temporelles de la polarisation. Des variations ultra-rapides de l'ordre de quelques picosecondes peuvent en effet être suivies par le détecteur de polarisation elliptique décrit précédemment. Dans cette configuration, le facteur limitant la vitesse de mesure est donc la vitesse de rotation de la lame quart d'onde.

Le mécanisme de détection THz de polarisation linéaire ou circulaire est expliqué ci-dessous en référence aux figures 2A et 2B. De manière simplifiée, l'excitation du gaz d'électrons à une extrémité du canal, qui décroît exponentiellement à l'approche de l'extrémité opposée, conduit à une tension continue $\Delta U$ aux bornes du canal. La distance caractéristique à laquelle la tension diminue est déterminée par le paramètre $L$. Si le canal est long ($L_g$ >2 $L$), l'excitation du plasma à une extrémité ne parvient pas à l'autre extrémité, et la tension continue $\Delta U$ chute à zéro sous la grille. Si le canal est court ($2L > L_g$), le plasma est excité dans toute la région sous la grille, en s'amortissant d'une extrémité à l'autre. Dans le cas de la détection d'un rayonnement polarisé linéairement, l'excitation des ondes de densité d'électrons peut se produire uniquement à une extrémité du canal et le signal de détection, $\Delta U_{\text{linéaire}}$, est déterminé par la différence de tension continue entre les deux extrémités de la grille (Fig. 2A). Pour une grille suffisamment longue cette différence (et, par conséquent, la détection) est maximale. Elle diminue avec la longueur de la grille (Fig. 2B) en 1/x'. Dans le cas de la détection de rayonnement ayant une polarisation circulaire ou elliptique, l'excitation du gaz d'électrons se produit par les deux côtés du canal, et le signal de détection, $\Delta U_{\text{circulaire}}$, est déterminé par la taille de la zone de superposition des excitations et par les valeurs des tensions continues apparaissant aux bornes du canal (Fig.2B).

Pour analyser le type de polarisation du rayonnement THz, il est préférable d'utiliser des transistors à grille courte (2L > Lg). En effet, si la grille est longue ($L_g$ » 2L, Figs. 2A, 2C), seule la détection de la polarisation linéaire est possible (2A). Dans le cas d'une grille courte (Fig. 2B), la variation du signal ne peut être due qu'à une variation de polarisation de la configuration circulaire à celles elliptique et/ou linéaire. En outre, le changement de signe du signal formé dans la zone de superposition des excitations correspond à un changement de sens de rotation du vecteur de polarisation.

Les propriétés non linéaires du transistor conduisent à un redressement du courant alternatif induit par le rayonnement incident en tension continue. La photo-réponse consiste en l'apparition d'une tension (ou d'un courant) continue entre la source et le drain, proportionnelle à la puissance de rayonnement incident. La longueur du canal du transistor considéré est beaucoup plus courte que la longueur d'onde de l'onde incidente. Le canal est également complètement couvert par la grille métallique.

Dans le cas de détection de rayonnement polarisé linéairement, une asymétrie entre la source et le drain est nécessaire pour induire un photo-voltage drain-source. Dans le cas d'une détection de rayonnement polarisé circulairement ou elliptiquement, pour induire un photovoltage drain-source représentant l'état de polarisation de rayonnement incident, il est nécessaire d'avoir une asymétrie entre la source et le drain pour chaque composante de polarisation détectée. De ce fait, l'ensemble de l'antenne peut être symétrique entre la source et le drain. Concernant la présente invention, cette asymétrie provient de la conception asymétrique des antennes grille-drain 42b, 32 et source-grille 31, 41b (voir Fig. 1).

Le régime de fonctionnement du FET en tant que détecteur THz dépend de la fréquence $\omega$ de rayonnement et de la longueur de grille $L_g$. Un paramètre important est $\omega\tau$, où $\tau$ est le temps de relaxation du moment des électrons. La valeur de ce paramètre détermine si les ondes de plasma sont excitées ($\omega\tau > 1$), ou non ($\omega\tau < 1$) dans le canal par le rayonnement incident. Le cas le plus fréquent est considéré, selon lequel $\omega\tau < 1$, de sorte que les oscillations de plasma sont fortement amorties ou se sont transformés en perturbations de densité de charge et que le transistor FET fonctionne comme un détecteur large bande.

D'autre part, suivant un mode de réalisation, la longueur $L_g$ de grille doit être inférieure ou égale à deux fois la longueur $L$ d'amortissement caractéristique. Un courant alternatif induit à la source peut alors se propager dans le canal au-dessous de la grille à une distance de l'ordre de $L$. Si la longueur de grille $L_g$ est beaucoup plus grande que la longueur d'amortissement $L$, alors le photo-voltage est généré dans une région très proche du contact de source et ne dépend donc pas de la longueur $L_g$. Toutefois, si $Lg < L$, alors le photo-voltage diminue comme $L/L_g$.

La condition aux limites à la source (x = 0) s'écrit : =

$$(U + z_sI)_{x=0} = U_s\cos(\omega t), \qquad (2)$$

où U et I sont la tension source-grille et le courant du canal alternatifs, respectivement, $z_s$ est l'impédance de l'antenne efficace 31, 41b pour les contacts source-grille, $U_s$ est la tension alternative fournie par l'antenne en conditions de circuit ouvert.

La quantité $U_s$ est liée à l'intensité du rayonnement entrant, J, et la sensibilité de l'antenne, $\beta$, par la relation :

$$U_s^2 = \beta\alpha_sJ, \qquad (3)$$

Il faut noter que la sensibilité $\beta\alpha_s$ dépend de la fréquence.

Une condition aux limites similaires doit être imposée du côté drain (x = $L_g$) par le remplacement de l'indice s par d. Le paramètre pertinent est le rapport entre l'impédance $z_s$ de l'antenne et l'impédance Z de transistor. L'impédance Z du transistor dépend de la longueur du canal, de la tension de polarisation de la grille et de la fréquence du rayonnement. Dans le cas limite $z_s \ll Z$, la condition aux limites se réduit à $(U)_{x=0} = U_s\cos(\omega t)$, dans le sens opposé limite $z_s \gg Z$ on

peut écrire que $(z_s l)_{x=0} = U_s cos(\omega t)$. Le premier cas limite a été jugé précédemment [8, 19, 20], avec l'hypothèse selon laquelle le rayonnement est appliqué seulement entre les contacts source et grille, et pour $U_0 = Ug - U_{th} > 0$, la photo-réponse est alors donnée par l'équation (4) suivante :

$$\delta U_{sd} = \frac{U_x^2}{4U_0}\left[1 - \frac{1}{2}\exp\left(-\frac{2L_g}{I}\right)\right]$$

Le cas où $U_0 \leq 0$ a été étudié dans la référence [15]. Il a été démontré que la photo-réponse du transistor possède un maximum autour du seuil. La dépendance de la photo-réponse en fonction de la polarisation de grille dans la région sous le seuil, $f(U_g)$, dépend du courant de fuite de grille continu et de l'impédance du transistor. Ainsi, en utilisant l'équation (3), le photo-voltage continu DC peut être réécrit comme suit :

$$\alpha U_{sd} = \beta \cdot J \cdot f(U_g), \qquad (5)$$

où la fonction $f(U_g)$ est décrite dans [15]. Pour $U_0$ positive, $f = 1/4\ U_0$.

Contrairement à l'approche standard, dans l'invention le rayonnement est amené des deux côtés du transistor. En d'autres termes, le couplage de rayonnement avec le canal du transistor est modélisé par deux antennes efficaces, dont l'une produit la première tension alternative $U_s$ entre la source et la grille, et l'autre produit la deuxième tension alternative $U_d$ entre le drain et la grille (voir Fig. 1). Les contributions de ces entrées à la photo-réponse $\delta U_s$ et $\delta U_d$ sont de signes opposés, de sorte que si les amplitudes et phases respectives sont égales, la photo-réponse résultante est nulle.

Dans le cas général, la réponse photovoltaïque est donnée par :

$$\delta U_{sd} = (\beta_s(\omega) \cdot f_s(U_g) - \beta_d(\omega) \cdot f_d(U_g)) \cdot J \qquad (6)$$

où $\delta U_{sd} = |U_s|^2 \cdot f_s(U_g)$, $\delta U_d = |U_d|^2 \cdot f_d(U_g)$, $U_s = \beta_s(\omega) \cdot J$, $U_d = \beta_d(\omega) \cdot J$.

La première tension alternative Us provoque une première perturbation de la densité de charges électriques du côté source du canal, qui se propage dans le canal vers le drain.

La deuxième tension alternative Ud provoque une deuxième perturbation de la densité de charges électriques du côté drain du canal, qui se propage dans le canal vers la source.

Le transistor est étant agencé pour générer une interférence, sensible à l'état de polarisation elliptique de l'onde, entre la première et la deuxième perturbation provoquées respectivement par les tensions alternatives Us et Ud entre la borne 21 de source et la borne 22 de drain. Cette interférence est à l'origine de la partie du signal électrique continu entre la source et le drain sensible à l'état de polarisation elliptique de l'onde.

Dans ces équations, $\beta_s$ et $\beta_d$ sont les sensibilités de la partie d'antenne 31, 41b source-grille et de la partie d'antenne 32, 42b drain-grille et les fonctions $fs(U_g)$ et $f_d(U_g)$ décrivent des photo-réponses en fonction de la tension de polarisation de la grille générées des côtés source et drain du canal.

Comme les résultats expérimentaux ci-dessous le montrent :

(i) l'efficacité de l'antenne dépend fortement de la fréquence du rayonnement incident,

(ii) les deux antennes efficaces sont sensibles à la polarisation du rayonnement : l'une d'elles est surtout sensible à la polarisation $E_x$ selon X, et l'autre à la polarisation $E_y$ selon Y. Pour la polarisation elliptique, les signaux alternatifs à la source et au drain sont déphasés d'un angle $\theta$ non nul (angle $\theta$ entre la première composante de polarisation $E_x$ suivant la première direction X et la deuxième composante de polarisation $E_y$ suivant la deuxième direction Y, ainsi que représenté à titre d'exemple à la figure 4 par exemple, pour le rayonnement polarisé circulairement $\theta = \pm\ \pi/2$). Le photo-voltage résultant, $\delta U_{sd}$, donne un terme d'interférence supplémentaire proportionnelle à $J^*(\beta_s\beta_d)^{1/2}*sin\theta*exp(-Lg/L)$. Ce terme est sensible à l'ellipticité du rayonnement incident (signe de $\theta$) et peut dominer si $\beta_s$ est à peu près égal à $\beta_d$.

D'une manière générale,

$$\delta U_{sd} = U_s - U_d + \left( \sqrt{U_d \cdot U_s} \cdot \sin \theta \cdot e^{-\left(\frac{Lg}{L}\right)} \right)$$

La tension continue ΔU de détection de l'état de polarisation elliptique de l'onde par interférence est :

$$\Delta U = \left( \sqrt{U_d \cdot U_s} \cdot \sin \theta \cdot e^{-\left(\frac{Lg}{L}\right)} \right)$$

D'une manière générale, $U_s$ est inférieure à 100 mV. D'une manière générale, $U_d$ est inférieure à 100 mV.
Dans un exemple numérique, par exemple pour $\theta \approx 76°$ pour lequel $\tan\theta=4$ et $\sin\theta=0.97$, on a :

Puissance incidente sur l'axe y : $P^y = \dfrac{U_a^2}{4.Z_s} = 1mW$

$U_a$ est l'amplitude de la tension induite sur l'antenne entre la source et la grille,
$Z_s$ est l'impédance de l'antenne efficace pour les contacts source-grille

$$U_s = \frac{U_a^2}{4} \cdot \frac{1}{U^\bullet}$$

*avec*

$$U^\bullet = \frac{2\eta k_B T}{e} = 25mV$$

η est le facteur d'idéalité, $k_B$ est la constante de Boltzmann, $T$ est la température, e est la charge de l'électron.

$$U_a^2 = 1mW.Z. \left( \frac{S_{ant.}}{S_{beam}} \right)$$

$Z$ = 10kΩ est l'impédance du canal, $S_{ant.}$ est la surface de l'antenne, $S_{beam}$ est la surface du faisceau dans le plan de l'antenne

$$\frac{S_{ant.}}{S_{beam}} = \frac{(50\mu m)^2}{(500\mu m)^2} = 10^{-2}$$

dans ce cas.

$$U_a^2 = 10^{-1} V^2$$

$$U_a = 316 \ mV$$

Donc $U_s = \dfrac{(316mV)^2}{100mV} \approx 1mV$

Donc, puissance incidente sur l'axe X :

$$P^x = \frac{(U_b)^2}{4 \cdot Z_s} = 0.25\,mW$$

Où $U_b$ est l'amplitude de la tension induite sur l'antenne entre la grille et le drain, avec

$$\tan \theta = \frac{P^y}{P^x} = \frac{U_s}{U_d}$$

D'où: $U_d$ = 0.25mV

$$\delta U_{sd} = U_s - U_d + \left( \sqrt{U_d \cdot U_s} \cdot \sin \theta \cdot e^{-\left(\frac{Lg}{L}\right)} \right) = 775\,\mu V$$

La tension continue ∆U de détection de l'état de polarisation elliptique de l'onde par interférence est dans cet exemple :

$$U_d . U_s . \sin \theta . e^{-\left(\frac{L_g}{l}\right)} = \sqrt{25.10^{-8}} . \sin \theta . 5.10^{-2} = 25\,\mu V . \sin \theta = \underline{25\,\mu V}$$

Jusqu'à présent, la polarimétrie THz n'était pas développée simplement par absence de détecteurs de polarisation circulaire et elliptique. Ce manque peut être comblé par la présente invention.

Potentiellement, la polarimétrie THz est un domaine d'études extrêmement important, s'agissant de l'identification de différents matériaux et de leurs propriétés, ainsi que celles des différentes sources de rayonnement THz. Il est possible de faire un parallèle entre les applications potentielles de la polarimétrie THz et celles de la gamme optique. En effet, l'interaction de la lumière polarisée avec la matière a permis l'essor de nombreuses applications. Celles-ci sont majoritairement basées sur la détermination de la structure intrinsèque des solides, mais aussi sur celle d'objets biologiques (par le biais de la microscopie de polarisation), sur les transitions quantiques, mais également sur les mesures astrophysiques d'objets très éloignés. De manière générale, la polarisation de la lumière en tant qu'outil permet d'étudier toutes sortes d'anisotropies de la matière comme : le comportement des gaz, des liquides et des solides dans les domaines des perturbations anisotropes (mécanique, acoustique, électrique, photonique), mais également la structure des matériaux optiquement anisotropes, ainsi que les contraintes élastiques dans les matériaux, etc.

Les informations sur la polarisation des ondes THz donnent également un élan supplémentaire au développement des applications existantes dans le domaine THz. De ce fait, pour le contrôle de la qualité des produits, la polarimétrie THz peut déterminer non seulement les défauts affectant la transparence du matériau sous forme de fissures et de cavités, mais aussi les défauts dus au stress et aux tensions internes, qui n'affectent que la polarisation de la lumière transmise. Concernant l'analyse chimique non destructive de substances organiques, y compris biologiques, les mesures de polarisation peuvent fournir une information supplémentaire qu'il est impossible d'extraire à partir d'études spectroscopiques simples. L'utilisation de la polarisation circulaire est également intéressante dans le domaine des télécommunications. Dans le cas d'un rayonnement polarisé linéairement, le récepteur doit être déployé dans le respect de la polarisation de l'onde incidente. Et dans le cas de la polarisation circulaire, un ajustement supplémentaire du récepteur n'est pas nécessaire.

Ainsi, le développement de la polarimétrie THz peut compléter les méthodes existantes d'analyse THz basées sur la définition de la puissance et de la fréquence du rayonnement. En conséquence, il est possible d'obtenir toutes les informations relatives aux objets étudiés dans la gamme THz.

Un domaine d'application peut également être la polarimétrie THz, pour l'analyse d'images dans le domaine du contrôle qualité. Une autre application possible peut être la caractérisation d'instrumentation de laboratoire (laser THz, par exemple) ou la caractérisation de matériaux (produits biologiques, par exemple).

Il est ainsi proposé un nouvel appareil permettant la mesure à température ambiante de la polarisation d'une radiation THz donnée. De manière synthétique, cet appareil comprend une antenne 2D, un transistor à effet de champ qui rectifie la radiation Térahertz, un circuit de lecture et une boîte de protection. La nouveauté de l'invention repose sur l'utilisation des FETs pour déterminer la polarisation de la radiation THz, et sur le design d'antenne qui permet d'utiliser ces FETs pour la détection de radiations THz polarisées circulairement. Nous proposons une antenne comprenant trois parties connectées aux trois contacts de transistor (source, drain et grille) et formant par exemple un angle droit. Grâce à cette géométrie, les composantes orthogonales de la polarisation de la radiation THz sont détectées. Ces deux composantes excitent alors le transistor FET de chaque côté du canal (source et drain). Quand le canal de transistor est assez court, les excitations se mélangent et il en résulte un signal se présentant comme une tension continue entre la source et le drain. Le dispositif permet de déterminer le changement d'hélicité de polarisation du faisceau (de circulaire droit à circulaire gauche) par le changement de signe du signal mesuré.

A la figure 5, l'antenne possède seulement deux lobes, reliés à la grille et à la source du transistor. L'antenne est sensible au rayonnement polarisé linéairement selon l'axe X. Ce rayonnement excite les ondes de densité d'électrons dans le canal du transistor, entre la grille et la source. L'excitation de ce canal sous la grille crée une tension continue drain-source, $\Delta U$, qui constitue le signal de détection. Une éventuelle composante de polarisation perpendiculaire à l'axe X ne contribuerait pas à l'excitation du gaz d'électrons et, par conséquent, ne pourrait être détectée par le transistor.

A la figure 5, l'antenne THz pour le transistor à effet de champ ne permet que la détection de rayonnement polarisé linéairement. X est l'axe de polarisation de l'antenne, D est le drain, S la source, G la grille et $\Delta U$ est le signal de détection.

L'invention permet de mesurer directement la polarisation circulaire ou elliptique d'une radiation THz. La valeur de la tension mesurée aux bornes du dispositif permet en effet la détermination directe des angles et des axes de polarisation du rayonnement considéré. Les caractéristiques de cette invention sont : sa rapidité, son faible bruit interne, sa facilité d'utilisation, son coût de production très peu élevé, sa possibilité d'intégration dans des matrices (mesures multi-pixels) et ses faibles dimensions. Le dispositif fonctionne à température ambiante et se caractérise également par sa faible consommation d'énergie.

Liste des références citées :

[1] S. D. Ganichev, J. Kiermaier, W. Weber, S. N. Danilov, D. Schuh, Ch. Gerl, W. Wegscheider, D. Bougeard, G. Abstreiter, et W. Prettl, Appl. Phys. Lett. 91, 091101 (2007).

[2] S. D. Ganichev, W. Weber, J. Kiermaier, S. N. Danilov, P. Olbrich, D. Schuh, W. Wegscheider, D. Bougeard, G. Abstreiter, et W. Prettl, J. Appl. Phys.103, 114504 (2008).

[3] S. N. Danilov, B. Wittmann, P. Olbrich, W. Eder, W. Prettl, L. E. Golub, E. V. Beregulin, Z. D. Kvon, N. N. Mikhailov, S. A. Dvoretsky, V. A. Shalygin, N. Q. Vinh, A. F. G. van der Meer, B. Murdin, et S. D. Ganichev, J. Appl. Phys.105, 013106 (2009).

[4] S. D. Ganichev, V. V. Bel'kov, Petra Schneider, E. L. Ivchenko, S. A. Tarasenko, W. Wegscheider, D. Weiss, D. Schuh, E. V. Beregulin, et W. Prettl, Phys. Rev. B., 035319 (2003).

[5] S. D. Ganichev, Petra Schneider, V. V. Bel'kov, E. L. Ivchenko, S. A. Tarasenko, W. Wegscheider, D. Weiss, D. Schuh, B. N. Murdin, P. J. Phillips, C. R. Pidgeon, D. G. Clarke, M. Merrick, P. Murzyn, E. V. Beregulin, et W. Prettl, Phys. Rev. B. (Rapid Communic.), 081302 (2003).

[6] H. Diehl, V. A. Shalygin, V. V. Bel'kov, C. Hoffmann, S. N. Danilov, T. Herrle, S. A. Tarasenko, D. Schuh, C. Gerl, W. Wegscheider, W. Prettl et S. D. Ganichev, New Journal Phys. 9, 349 (2007).

[7] J. Karch, P. Olbrich, M. Schmalzbauer, C. Zoth, C. Brinsteiner, M. Fehrenbacher, U. Wurstbauer, M. Glazov, S. A. Tarasenko, E. L. Ivchenko, D. Weiss, J. Eroms, et S. D. Ganichev, Phys. Rev. Lett. 97, 182107 (2010).

[8] M. Diakonov et M. S. Shur, IEEE Trans Electron.Devices 43, 380 (1996).

[9] W. Knap, Y. Deng, S. Rumyantsev et M. S. Shur, Appl. Phys. Lett., 81, 4637 (2002).

[10] X. G. Peralta, S. J. Allen, M. C. Wanke, N. E. Harff, J. A. Simmons, M. P. Lilly, J. L. Reno, P. J. Burke, et J. P. Eisenstein, Appl. Phys. Lett. 81, 1627 (2002).

[11] G. C. Dyer, J. D. Crossno, G. R. Aizin, E. A. Shaner, M.C. Wanke, J. L. Reno, et S. J. Allen, J. Phys. : Condens. Mater 21, 195803 (2009).

[12] E. A. Shaner, Mark Lee, M. C. Wanke, A. D. Grine, et J. L. Reno, S. J. Allen, Appl. Phys. Lett. 87, 193507 (2005).

[13] D. B. Veksler, A. V. Muravjov, V. Yu. Kachorovskii, T. A. Elkhatib, K. N. Salama, X.-C. Zhang, et M. S. Shur, Solid-State Electron. 53, 571 (2009).

[14] W. Knap, F. Teppe, Y. Meziani, N. Dyakonova, J. Lusakowski, F. Boeuf, T. Skotnicki, D. Maude, S. Rumyantsev, et M. S. Shur, Appl. Phys. Lett. 85, 675 (2004).

[15] W. Knap, V. Kachorovskii, Y. Deng, S. Rumyantsev, J.-Q. Lu, R. Gaska, M. S. Shur, G. Simin, X. Hu, M. Asif Khan, C. A. Saylor, et L. C. Brunel, J. Appl. Phys., 91, 9346 (2002).

[16] R. Tauk, F. Teppe, S. Boubanga, D. Coquillat, W. Knap, Y. M. Meziani, C. Gallon, F. Boeuf, T. Skotnicki, C. Fenouillet-Beranger, D. K. Maude, S. Rumyantsev, et M. S. Shur, Appl. Phys. Lett. 89, 253511 (2006).

[17] M. Sakowicz, J. Lusakowski, K. Karpierz, M. Grynberg, W. Knap, et W. Gwarek, J. Appl. Phys. 104, 024519 (2008).

[18] S. Kim, Jeramy D. Zimmerman, P. Focardi, A. C. Gossard, D. H. Wu, et M. S. Sherwin, Appl. Phys. Lett. 92, 253508 (2008).

[19] W. Knap, D. Coquillat, N. Dyakonova, F. Teppe, O. Klimenko, H. Videlier, S. Nadar, J. Lusakowski, G. Valusis, F. Schuster, B. Giffard, T. Skotnicki, C. Gaquière, et A. El Fatimy C. R. Physique, 11, 433 (2010).

[20] D. Veksler, F. Teppe, A. P. Dmitriev, V. Yu. Kachorovskii, W. Knap, et M. S. Shur, Phys. Rev. B 73, 125328 (2006).

## Revendications

1. Dispositif (1) de mesure de l'état de polarisation d'une onde incidente de fréquence supérieure à 10 GHz et inférieure à 30 THz, le dispositif comportant :

    - au moins un transistor à effet de champ (2) comportant au moins une borne (21) de source, au moins une borne (22) de drain et au moins une borne (23) de grille,
    - une antenne (3) de réception de l'onde incidente de fréquence supérieure à 10 GHz et inférieure à 30 THz, reliée au moins à la borne (23) de grille,

    la borne (21) de source et la borne (22) de drain étant reliées à un circuit (5) pour la mesure d'un signal électrique ($\Delta$U) de détection présent entre la borne (21) de source et la borne (22) de drain,
    **caractérisé en ce que**
    l'antenne (3) de réception de l'onde incidente de fréquence supérieure à 10 GHz et inférieure à 30 THz est bidirectionnelle, est prévue à l'extérieur du transistor à effet de champ (2), est distincte des bornes (21, 22, 23) du transistor (2) et comporte une première partie (31) d'antenne reliée à la borne (21) de source, une deuxième partie (32) d'antenne reliée à la borne (22) de drain et une troisième partie (33) d'antenne bidirectionnelle reliée à la borne (23) de grille,
    la première partie (31) d'antenne et la troisième partie (33) d'antenne bidirectionnelle étant agencées pour détecter une première composante de polarisation de l'onde, colinéaire à une première direction déterminée (X) et provoquant l'apparition dans le transistor (2) entre la borne (21) de source et la borne (23) de grille d'une première tension alternative (Us) de détection de la première composante suivant la première direction (X),
    la deuxième partie (32) d'antenne et la troisième partie (33) d'antenne bidirectionnelle étant agencées pour détecter une deuxième composante de polarisation de l'onde, colinéaire à une deuxième direction déterminée (Y) et provoquant l'apparition dans le transistor (2) entre la borne (22) de drain et la borne (23) de grille d'une deuxième tension alternative (Ud) de détection de la deuxième composante suivant la deuxième direction (Y),
    la première direction (X) étant non parallèle à la deuxième direction (Y) et étant non confondue avec la deuxième direction (Y),
    le transistor (2) étant agencé pour générer, comme signal électrique ($\Delta$U) de détection entre la borne (21) de source et la borne (22) de drain, une tension continue ($\Delta$U) de détection dont une partie est déterminée par l'état de polarisation elliptique de l'onde par interférence dans le transistor (2) entre la première tension alternative (Us) de détection et la deuxième tension alternative (Ud) de détection, le circuit (5) étant prévu pour analyser l'état de polarisation elliptique de l'onde par mesure du signal électrique ($\Delta$U) de détection entre la borne (21) de source et la borne (22) de drain.

2. Dispositif suivant la revendication 1, **caractérisé en ce que** le transistor (2) est agencé pour avoir une longueur (Lg) de grille (G), prise dans la direction allant de la source (S) au drain (D), inférieure ou égale à deux fois la longueur (L) d'amortissement caractéristique de la première tension alternative (Us) et de la deuxième tension alternative (Ud) dans le canal du transistor (2)..

3. Dispositif suivant la revendication 1 ou 2, **caractérisé en ce que** le transistor (2) est agencé pour avoir une longueur (Lg) de grille (G), prise dans la direction allant de la source (S) au drain (D), inférieure ou égale à deux fois une longueur (L) d'amortissement caractéristique égale à

$$L = \sqrt{\frac{\mu |U|}{\omega}}$$

où $\omega$ est la pulsation de l'onde, $\mu$ est la mobilité des électrons dans le canal du transistor (2), U est l'écart de tension au seuil , U = $U_t$-$U_{gs}$ pour $U_{gs}$>$U_t$ et U= $\eta$kT/e pour $U_{gs}$≤$U_t$, où $U_t$ est la tension de seuil du transistor (2) et $U_{gs}$ est la tension continue de polarisation appliquée entre la borne de grille et la borne de source, $\eta$ est le coefficient d'idéalité, T est la température, k est la constante de Boltzmann.

4. Dispositif suivant l'une quelconque des revendications précédentes, **caractérisé en ce que** la première partie (31) d'antenne comporte un premier bras (41a) d'antenne et la troisième partie (33) d'antenne bidirectionnelle comporte un troisième bras (41b) d'antenne, le premier bras (41a) d'antenne et le troisième bras (41b) d'antenne étant dirigés suivant la première direction déterminée (X) en étant opposés l'un de l'autre pour la détection de la première composante de polarisation de l'onde, colinéaire à la première direction (X),
la deuxième partie (32) d'antenne comportant un deuxième bras (42a) d'antenne et la troisième partie (33) d'antenne bidirectionnelle comportant un quatrième bras (42b) d'antenne, le deuxième bras (42a) d'antenne et le quatrième bras (42b) d'antenne étant dirigés suivant la deuxième direction déterminée (Y) en étant opposés l'un de l'autre pour la détection de la deuxième composante de polarisation de l'onde, colinéaire à la deuxième direction (Y).

5. Dispositif suivant l'une quelconque des revendications précédentes, **caractérisé en ce que** la première direction (X) et la deuxième direction (Y) sont perpendiculaires.

6. Dispositif suivant la revendication 4, **caractérisé en ce que** le premier bras (41a) est symétrique par rapport à la première direction (X).

7. Dispositif suivant la revendication 4, **caractérisé en ce que** le deuxième bras (41b) est symétrique par rapport à la première direction (X).

8. Dispositif suivant la revendication 4, **caractérisé en ce que** le troisième bras (42a) est symétrique par rapport à la deuxième direction (Y).

9. Dispositif suivant la revendication 4, **caractérisé en ce que** le quatrième bras (42b) est symétrique par rapport à la deuxième direction (Y).

10. Dispositif suivant la revendication 4, **caractérisé en ce que** le premier bras (41a) et/ou le deuxième bras (41b) et/ou le troisième bras (42a) et/ou le quatrième bras (42b) sont de forme triangulaire.

11. Dispositif suivant la revendication 4, **caractérisé en ce que** le premier bras (41a) et/ou le deuxième bras (41b) et/ou le troisième bras (42a) et/ou le quatrième bras (42b) sont chacun planaires.

12. Dispositif suivant l'une quelconque des revendications précédentes, **caractérisé en ce qu'**il comporte en outre au moins une lame (LAM), la lame étant quart d'onde par rapport à la fréquence de l'onde incidente, la lame étant mise en rotation par un dispositif rotatif (ROT) autour d'un axe (AX) de rotation azimutal, la lame étant traversée par cette onde incidente pour la transmettre à l'antenne (3).

13. Dispositif suivant la revendication 12, **caractérisé en ce qu'**il est prévu un dispositif pour déterminer l'angle (ANG) de rotation de la lame (LAM) autour de l'axe (AX) de rotation en fonction du temps,
le circuit étant relié à un dispositif (COMP) de traitement de données permettant une mesure différentielle de l'état de polarisation elliptique en fonction de l'angle (ANG) de rotation et en fonction du signal électrique ($\Delta$U) de détection.

**Patentansprüche**

1. Vorrichtung (1) zum Messen des Polarisationszustands einer einfallenden Welle mit einer Frequenz über 10 GHz und unter 30 THz, wobei die Vorrichtung aufweist:

- mindestens einen Transistor mit Feldeffekt (2), der mindestens eine Quellenklemme (21), mindestens eine Drainklemme (22) und mindestens eine Gitterklemme (23) aufweist,
- eine Empfangsantenne (3) der einfallenden Welle mit einer Frequenz über 10 GHz und unter 30 THz, die mindestens mit der Gitterklemme (23) verbunden ist,

wobei die Quellenklemme (21) und die Drainklemme (22) mit einem Kreis (5) für die Messung eines zwischen der Quellenklemme (21) und der Drainklemme (22) vorhandenen elektrischen Detektionssignals ($\Delta$U) verbunden sind, **dadurch gekennzeichnet, dass** die Empfangsantenne (3) der einfallenden Welle mit einer Frequenz über 10 GHz und unter 30 THz bidirektional ist, außerhalb des Transistors mit Feldeffekt (2) vorgesehen ist, sich von den Klemmen (21, 22, 23) des Transistors (2) unterscheidet und einen ersten Antennenteil (31), der mit der Quellenklemme (21) verbunden ist, einen zweiten Antennenteil (32), der mit der Drainklemme (22) verbunden ist, und einen bidirektionalen dritten Antennenteil (33), der mit der Gitterklemme (23) verbunden ist, aufweist,

- wobei der erste Antennenteil (31) und der bidirektionale dritte Antennenteil (33) ausgebildet sind, um eine erste Polarisationskomponente der Welle zu ermitteln, die kolinear zu einer ersten bestimmten Richtung (X) ist und das Auftreten im Transistor (2) zwischen der Quellenklemme (21) und der Gitterklemme (23) einer ersten Detektions-Wechselspannung (Us) der ersten Komponente gemäß der ersten Richtung (X) hervorruft,
- wobei der zweite Antennenteil (32) und der bidirektionale dritte Antennenteil (33) ausgebildet sind, um eine zweite Polarisationskomponente der Welle zu ermitteln, die kolinear zu einer zweiten bestimmten Richtung (Y) ist und das Auftreten im Transistor (2) zwischen der Drainklemme (22) und der Gitterklemme (23) einer zweiten Detektions-Wechselspannung (Ud) der zweiten Komponente gemäß der zweiten Richtung (Y) hervorruft,

wobei die erste Richtung (X) nicht parallel zur zweiten Richtung (Y) ist und nicht mit der zweiten Richtung (Y) zusammenfällt, wobei der Transistor (2) ausgebildet ist, um als elektrisches Detektionssignal ($\Delta$U) zwischen der Quellenklemme (21) und der Drainklemme (22) eine Detektions-Gleichspannung ($\Delta$U) zu erzeugen, von der ein Teil von dem elliptischen Polarisationszustand der Welle durch Interferenz in dem Transistor (2) zwischen der ersten Detektions-Wechselspannung (Us) und der zweiten Detektions-Wechselspannung (Ud) bestimmt ist, wobei der Kreis (5) vorgesehen ist, um den elliptischen Polarisationszustand der Welle durch Messen des elektrischen Detektionssignals ($\Delta$U) zwischen der Quellenklemme (21) und der Drainklemme (22) zu analysieren.

2. Vorrichtung nach Anspruch 1, **dadurch gekennzeichnet, dass** der Transistor (2) ausgebildet ist, um eine Länge (Lg) eines Gitters (G), gemessen in der Richtung von der Quelle (S) zum Drain (D), zu haben, die kleiner oder gleich dem Doppelten der charakteristischen Dämpfungslänge (L) der ersten Wechselspannung (Us) und der zweiten Wechselspannung (Ud) im Kanal des Transistors (2) ist.

3. Vorrichtung nach Anspruch 1 oder 2, **dadurch gekennzeichnet, dass** der Transistor (2) ausgebildet ist, um eine Länge (Lg) eines Gitters (G), gemessen in der Richtung von der Quelle (S) zum Drain (D), zu haben, die kleiner oder gleich dem Doppelten einer charakteristischen Dämpfungslänge (L) gleich

$$L = \sqrt{\frac{\mu|U|}{\omega}}$$

ist, wobei $\omega$ die Schwingung der Welle ist, $\mu$ die Mobilität der Elektronen im Kanal des Transistors (2) ist, U die Abweichung der Spannung vom Grenzwert ist, $U = U_t - U_{gs}$ für $U_{gs} > U_t$ und $U = \eta kT/e$ für $U_{gs} \leq U_t$, wobei $U_t$ die Grenzwertspannung des Transistors (2) ist und $U_{gs}$ die angelegte Polarisations-Gleichspannung zwischen der Gitterklemme und der Quellenklemme ist, $\eta$ der Idealitätsfaktor ist, T die Temperatur ist, k die Boltzmann-Konstante ist.

4. Vorrichtung nach einem der vorangehenden Ansprüche, **dadurch gekennzeichnet, dass** der erste Antennenteil (31) einen ersten Antennenarm (41a) und der bidirektonale dritte Antennenteil (33) einen dritten Antennenarm (41b) aufweist, wobei der erste Antennenarm (41a) und der dritte Antennenarm (41b) gemäß der ersten bestimmten Richtung (X) ausgerichtet sind, indem sie für die Detektion der ersten Polarisationskomponente der Welle, die kolinear zur ersten Richtung (X) ist, einander gegenüber sind,
wobei der zweite Antennenteil (32) einen zweiten Antennenarm (42a) und der bidirektionale dritte Antennenteil (33) einen vierten Antennenarm (42b) aufweist, wobei der zweite Antennenarm (42a) und der vierte Antennenarm (42b) gemäß der zweiten bestimmten Richtung (Y) ausgerichtet sind, indem sie für die Detektion der zweiten Polarisationskomponente der Welle, die kolinear zur zweiten Richtung (Y) ist, einander gegenüber sind.

5. Vorrichtung nach einem der vorangehenden Ansprüche, **dadurch gekennzeichnet, dass** die erste Richtung (X) und die zweite Richtung (Y) senkrecht sind.

6. Vorrichtung nach Anspruch 4, **dadurch gekennzeichnet, dass** der erste Arm (41a) im Verhältnis zur ersten Richtung (X) symmetrisch ist.

7. Vorrichtung nach Anspruch 4, **dadurch gekennzeichnet, dass** der zweite Arm (41b) im Verhältnis zur ersten Richtung (X) symmetrisch ist.

8. Vorrichtung nach Anspruch 4, **dadurch gekennzeichnet, dass** der dritte Arm (42a) im Verhältnis zur zweiten Richtung (Y) symmetrisch ist.

9. Vorrichtung nach Anspruch 4, **dadurch gekennzeichnet, dass** der vierte Arm (42b) im Verhältnis zur zweiten Richtung (Y) symmetrisch ist.

10. Vorrichtung nach Anspruch 4, **dadurch gekennzeichnet, dass** der erste Arm (41a) und/oder der zweite Arm (41b) und/oder der dritte Arm (42a) und/oder der vierte Arm (42b) dreieckig geformt sind.

11. Vorrichtung nach Anspruch 4, **dadurch gekennzeichnet, dass** der erste Arm (41a) und/oder der zweite Arm (41b) und/oder der dritte Arm (42a) und/oder der vierte Arm (42b) jeweils planar sind.

12. Vorrichtung nach einem der vorangehenden Ansprüche, **dadurch gekennzeichnet, dass** sie ferner mindestens eine Lamelle (LAM) aufweist, wobei die Lamelle im Verhältnis zur Frequenz der einfallenden Welle Viertelwelle ist, wobei die Lamelle von einer Rotationsvorrichtung (ROT) um eine azimutale Rotationsachse (AX) in Rotation versetzt wird, wobei die Lamelle von dieser einfallenden Welle durchquert wird, um sie an die Antenne (3) zu übertragen.

13. Vorrichtung nach Anspruch 12, **dadurch gekennzeichnet, dass** eine Vorrichtung vorgesehen ist, um den Rotationswinkel (ANG) der Lamelle (LAM) um die Rotationsachse (AX) in Abhängigkeit von der Zeit zu bestimmen, wobei der Kreis mit einer Datenverarbeitungsvorrichtung (COMP) verbunden ist, was eine gestaffelte Messung des elliptischen Polarisationszustands in Abhängigkeit vom Rotationswinkel (ANG) und in Abhängigkeit vom elektrischen Detektionssignal ($\Delta$U) erlaubt.

## Claims

1. A device (1) for measuring the polarisation state of an incident wave of frequency greater than 10 GHz and less than 30 THz, the device comprising:

   - at least one field-effect transistor (2) comprising at least one source terminal (21), at least one drain terminal (22) and at least one gate terminal (23),
   - an antenna (3) for receiving the incident wave of frequency greater than 10 GHz and less than 30 THz, connected at least to the gate terminal (23),

   the source terminal (21) and the drain terminal (22) being connected to a circuit (5) for measuring an electric detection signal ($\Delta$U) present between the source terminal (21) and the drain terminal (22),
   **characterized in that**
   the antenna (3) for receiving the incident wave of frequency greater than 10 GHz and less than 30 THz is bidirectional, is provided outside the field-effect transistor (2), is separate from the terminals (21, 22, 23) of the transistor (2) and comprises a first antenna part (31) connected to the source terminal (21), a second antenna part (32) connected to the drain terminal (22) and a bidirectional third antenna part (33) connected to the gate terminal (23),
   the first antenna part (31) and the bidirectional third antenna part (33) being arranged to detect a first polarisation component of the wave, colinear to a first determined direction (X) and causing the appearance in the transistor (2) between the source terminal (21) and the gate terminal (23) of a first alternative detection voltage (Us) for detection of the first component in the first direction (X),
the second antenna part (32) and the bidirectional third antenna part (33) being arranged to detect a second polarisation component of the wave, colinear to a second determined direction (Y) and causing the appearance in the transistor (2) between the drain terminal (22) and the gate terminal (23) of a second alternative detection voltage (Ud) for detection of the second component in the second direction (Y),
the first direction (X) being not parallel to the second direction (Y) and not being identical to the second direction (Y),
the transistor (2) being arranged to generate, as electric detection signal ($\Delta U$) between the source terminal (21) and the drain terminal (22), a continuous detection voltage ($\Delta U$), a part of which is determined by the elliptical polarisation state of the wave by interference in the transistor (2) between the first alternative detection voltage (Us) and the second alternative detection voltage (Ud), the circuit (5) being provided to analyse the elliptical polarisation state of the wave by measuring the electric detection signal ($\Delta U$) between the source terminal (21) and the drain terminal (22).

2.  The device according to claim 1, **characterized in that** the transistor (2) is arranged to have a gate (G) length (Lg), taken in the direction going from the source (S) to the drain (D), less than or equal to twice the characteristic damping distance (L) of the first alternative voltage (Us) and of the second alternative voltage (Ud) in the channel of the transistor (2)..

3.  The device according to claim 1 or 2, **characterized in that** the transistor (2) is arranged to have a gate (G) length (Lg), taken in the direction going from the source (S) to the drain (D), less than or equal to twice a characteristic damping distance (L) equal to

$$ L = \sqrt{\frac{\mu |U|}{\omega}}, $$

where $\omega$ is the pulsation of the wave, $\mu$ is the mobility of electrons in the channel of the transistor (2), U is the voltage difference at the threshold, $U = U_t - U_{gs}$ for $U_{gs} > U_t$ and $U = \eta kT/e$ for $U_{gs} \leq U_t$, where $U_t$ is the threshold voltage of the transistor (2) and $U_{gs}$ is the continuous polarisation voltage applied between the gate terminal and the source terminal, $\eta$ is the ideality coefficient, T is the temperature, k is the Boltzmann constant.

4.  The device according to any one of the preceding claims, **characterized in that** the first antenna part (31) comprises a first antenna arm (41a) and the bidirectional third antenna part (33) comprises a third antenna arm (41b), the first antenna arm (41a) and the third antenna arm (41b) being directed in the first determined direction (X) by being opposite each other for detection of the first polarisation component of the wave, colinear to the first direction (X), the second antenna part (32) comprising a second antenna arm (42a) and the bidirectional third antenna part (33) comprising a fourth antenna arm (42b), the second antenna arm (42a) and the fourth antenna arm (42b) being directed in the second determined direction (Y) by being opposite each other for detection of the second polarisation component of the wave, colinear to the second direction (Y).

5.  The device according to any one of the preceding claims, **characterized in that** the first direction (X) and the second direction (Y) are perpendicular.

6.  The device according to claim 4, **characterized in that** the first arm (41 a) is symmetrical relative to the first direction (X).

7.  The device according to claim 4, **characterized in that** the second arm (41b) is symmetrical relative to the first direction (X).

8.  The device according to claim 4, **characterized in that** the third arm (42a) is symmetrical relative to the second direction (Y).

9.  The device according to claim 4, **characterized in that** the fourth arm (42b) is symmetrical relative to the second direction (Y).

10. The device according to claim 4, **characterized in that** the first arm (41a) and/or the second arm (41b) and/or the third arm (42a) and/or the fourth arm (42b) are triangular in form.

11. The device according to claim 4, **characterized in that** the first arm (41a) and/or the second arm (41b) and/or the third arm (42a) and/or the fourth arm (42b) are each planar.

12. The device according to any one of the preceding claims, **characterized in that** it comprises also at least one blade (LAM), the blade being a quarter wave blade relative to the frequency of the incident wave, the blade being set in rotation by a rotary device (ROT) about an azimuth axis (AX) of rotation, the blade being traversed by this incident wave to transmit it to the antenna (3).

13. The device according to claim 12, **characterized in that** a device is provided for determining the angle (ANG) of rotation of the blade (LAM) about the axis (AX) of rotation as a function of the time,
the circuit being connected to a data-processing device (COMP) for differential measuring of the elliptical polarisation state as a function of the angle (ANG) of rotation and as a function of the electric detection signal (ΔU).

# FIG. 1

# FIG. 2A

# FIG. 2B

## FIG. 3

ANG

THz

AX

ROT

AX

LAM

Lumière polarisée

λ/4
Lame rotative

1

Détecteur

COMP

Traitement de données

## FIG. 4

Y

E_y

θ

E_x

X

## FIG. 5

D

G

S

ΔU

X

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. D. GANICHEV ; J. KIERMAIER ; W. WEBER ; S. N. DANILOV ; D. SCHUH ; CH. GERL ; W. WEGSCHEIDER ; D. BOUGEARD ; G. ABSTREITER ; W. PRETTL.** *Appl. Phys. Lett.,* 2007, vol. 91, 091101
- **S. D. GANICHEV ; W. WEBER ; J. KIERMAIER ; S. N. DANILOV ; P. OLBRICH ; D. SCHUH ; W. WEGSCHEIDER ; D. BOUGEARD ; G. ABSTREITER ; W. PRETTL.** *J. Appl. Phys.,* 2008, vol. 103, 114504
- **S. N. DANILOV ; B. WITTMANN ; P. OLBRICH ; W. EDER ; W. PRETTL ; L. E. GOLUB ; E. V. BEREGULIN ; Z. D. KVON ; N. N. MIKHAILOV ; S. A. DVORETSKY.** *J. Appl. Phys.,* 2009, vol. 105, 013106
- **S. D. GANICHEV ; V. V. BEL'KOV ; PETRA SCHNEIDER ; E. L. IVCHENKO ; S. A. TARASENKO ; W. WEGSCHEIDER ; D. WEISS ; D. SCHUH ; E. V. BEREGULIN ; W. PRETTL.** *Phys. Rev. B.,* 2003, 035319
- **S. D. GANICHEV ; PETRA SCHNEIDER ; V. V. BEL'KOV ; E. L. IVCHENKO ; S. A. TARASENKO ; W. WEGSCHEIDER ; D. WEISS ; D. SCHUH ; B. N. MURDIN ; P. J. PHILLIPS.** *Phys. Rev. B. (Rapid Communic.),* 2003, 081302
- **H. DIEHL ; V. A. SHALYGIN ; V. V. BEL'KOV ; C. HOFFMANN ; S. N. DANILOV ; T. HERRLE ; S. A. TARASENKO ; D. SCHUH ; C. GERL ; W. WEGSCHEIDER.** *New Journal Phys.,* 2007, vol. 9, 349
- **J. KARCH ; P. OLBRICH ; M. SCHMALZBAUER ; C. ZOTH ; C. BRINSTEINER ; M. FEHRENBACHER ; U. WURSTBAUER ; M. GLAZOV ; S. A. TARASENKO ; E. L. IVCHENKO.** *Phys. Rev. Lett.,* 2010, vol. 97, 182107
- **M. DIAKONOV ; M. S. SHUR.** *IEEE Trans Electron.Devices,* 1996, vol. 43, 380
- **W. KNAP ; Y. DENG ; S. RUMYANTSEV ; M. S. SHUR.** *Appl. Phys. Lett.,* 2002, vol. 81, 4637
- **X. G. PERALTA ; S. J. ALLEN ; M. C. WANKE ; N. E. HARFF ; J. A. SIMMONS ; M. P. LILLY ; J. L. RENO ; P. J. BURKE ; J. P. EISENSTEIN.** *Appl. Phys. Lett.,* 2002, vol. 81, 1627

- **G. C. DYER ; J. D. CROSSNO ; G. R. AIZIN ; E. A. SHANER ; M.C. WANKE ; J. L. RENO ; S. J. AL-LEN.** *J. Phys. : Condens. Mater,* 2009, vol. 21, 195803
- **E. A. SHANER ; MARK LEE ; M. C. WANKE ; A. D. GRINE ; J. L. RENO ; S. J. ALLEN.** *Appl. Phys. Lett.,* 2005, vol. 87, 193507
- **D. B. VEKSLER ; A. V. MURAVJOV ; V. YU. KACHOROVSKII ; T. A. ELKHATIB ; K. N. SALAMA ; X.-C. ZHANG ; M. S. SHUR.** *Solid-State Electron.,* 2009, vol. 53, 571
- **W. KNAP ; F. TEPPE ; Y. MEZIANI ; N. DYAKONOVA ; J. LUSAKOWSKI ; F. BOEUF ; T. SKOTNICKI ; D. MAUDE ; S. RUMYANTSEV ; M. S. SHUR.** *Appl. Phys. Lett,* 2004, vol. 85, 675
- **W. KNAP ; V. KACHOROVSKII ; Y. DENG ; S. RUMYANTSEV ; J.-Q. LU ; R. GASKA ; M. S. SHUR ; G. SIMIN ; X. HU ; M. ASIF KHAN.** *J. Appl. Phys.,* 2002, vol. 91, 9346
- **R. TAUK ; F. TEPPE ; S. BOUBANGA ; D. COQUILLAT ; W. KNAP ; Y. M. MEZIANI ; C. GALLON ; F. BOEUF ; T. SKOTNICKI ; C. FE-NOUILLET-BERANGER.** *Appl. Phys. Lett.,* 2006, vol. 89, 253511
- **M. SAKOWICZ ; J. LUSAKOWSKI ; K. KARPIERZ ; M. GRYNBERG ; W. KNAP ; W. GWAREK.** *J. Appl. Phys.,* 2008, vol. 104, 024519
- **S. KIM ; JERAMY D. ZIMMERMAN ; P. FOCARDI ; A. C. GOSSARD ; D. H. WU ; M. S. SHERWIN.** *Appl. Phys. Lett.,* 2008, vol. 92, 253508
- **W. KNAP ; D. COQUILLAT ; N. DYAKONOVA ; F. TEPPE ; O. KLIMENKO ; H. VIDELIER ; S. NADAR ; J. LUSAKOWSKI ; G. VALUSIS ; F. SCHUSTER.** *C. R. Physique,* 2010, vol. 11, 433
- **D. VEKSLER ; F. TEPPE ; A. P. DMITRIEV ; V. YU. KACHOROVSKII ; W. KNAP ; M. S. SHUR.** *Phys. Rev. B,* 2006, vol. 73, 125328